# EUROPEAN PATENT APPLICATION

(11) **EP 1 732 110 A2**
(43) Date of publication of application: **13.12.2006**
(21) Application number: 06011516.9
(22) Date of filing: 02.06.2006
(51) Int. Cl.: H01L 21/20

(54) **Compound semiconductor substrate, epitaxial substrate, processes for producing compound semiconductor substrate and epitaxial substrate**

(30) Priority: 10.06.2005 JP 2005171481
(71) Applicant: Sumitomo Electric Industries, Ltd., Osaka-shi, Osaka 541-0041 (JP)
(72) Inventor: Nishiura, Takayuki, 1-1 Koyakita 1-chome Itami-shi Hyogo (JP); Horie, Yusuke, 1-1 Koyakita 1-chome Itami-shi Hyogo (JP); Tsubokura, Mitsutaka, 1-1 Koyakita 1-chome Itami-shi Hyogo (JP); Ohama, Osamu, 1-3 Shimaya 1-chom Konohana-ku Osaka-shi (JP)
(74) Representative: Grünecker, Kinkeldey, Stockmair & Schwanhäusser Anwaltssozietät

(57) **Abstract**

A compound semiconductor substrate includes a substrate composed of a p-type compound semiconductor; and a substance containing p-type impurity atoms, the substance being bonded to a surface of the substrate.

## Description

### BACKGROUND OF THE INVENTION

### Field of the Invention

The present invention relates to compound semiconductor substrates, epitaxial substrates, and processes for producing the compound semiconductor substrates and the epitaxial substrates.

### Description of the Background Art

It is known that a method for making a compound semiconductor wafer having a high-quality clean mirror surface, the process including a cleaning step of cleaning a polished wafer, the cleaning step containing a cleaning substep of the wafer with alkaline agent, as is disclosed in Japanese Unexamined Patent Application Publication No. 11-204471.

It is also known that a method for treating a surface of a compound semiconductor substrate with an organic solvent solution containing sulfur, as is disclosed in Japanese Patent No. 2657265. In this method, sulfur remaining on the surface of the compound semiconductor substrate stabilizes the surface of the compound semiconductor substrate.

However, in the method disclosed in Japanese Unexamined Patent Application Publication No. 11-204471, the polished and cleaned wafer may be contaminated by exposing the wafer to an atmosphere in a clean room after polishing and cleaning. For example, impurities may be deposited on a surface of the wafer.

Furthermore, inorganic compounds, such as sulfur oxides (SOₓ) and nitrogen oxides (NOₓ), and organic compounds such as alcohols are contained as impurities in an atmosphere in a clean room or the like. The adhesion of such impurities to a surface of a wafer may change the electrical properties of the surface of the wafer depending on the types of the impurities and the amounts of the impurities. The formation of an epitaxial film on the surface of the wafer may cause abnormal electrical properties of the resulting epitaxial film.

In the method described in Japanese Patent No. 2657265, sulfur remaining on the surface of the wafer is disadvantageously vaporized by, for example, heating a wafer in forming an epitaxial film on the wafer due to high vapor pressure of sulfur. As a result, the concentration of sulfur on the surface of the wafer decreases, thus reducing the effect of stabilizing the surface of the wafer.

### SUMMARY OF THE INVENTION

Accordingly, it is an object of the present invention to provide a compound semiconductor substrate and an epitaxial substrate that have target surface electrical properties and processes for producing the compound semiconductor substrate and the epitaxial substrate.

To overcome the problems, a compound semiconductor substrate of the present invention includes a substrate composed of a p-type compound semiconductor; and a substance containing p-type impurity atoms, the substance being bonded to a surface of the substrate.

In the compound semiconductor substrate of the present invention, for example, even when n-type impurities present in an atmosphere adhere to the surface of the substrate, electrical properties of the surface of the substrate are negligibly changed because the substance containing the p-type impurity atoms is bonded to the surface of the substrate. Therefore, the compound semiconductor substrate of the present invention has target electrical properties of the surface.

The substance preferably contains zinc atoms as the impurity atoms. Furthermore, the substance preferably contains magnesium atoms as the impurity atoms.

A compound semiconductor substrate of the present invention includes a substrate composed of an n-type compound semiconductor; and a substance containing silicon atoms as n-type impurity atoms, the substance being bonded to a surface of the substrate. Furthermore, a compound semiconductor substrate of the present invention includes a substrate composed of an n-type compound semiconductor; and a substance containing tin atoms as an n-type impurity atoms, the substance being bonded to a surface of the substrate.

In the compound semiconductor substrate of the present invention, for example, even when p-type impurities present in an atmosphere adhere to the surface of the substrate, electrical properties of the surface of the substrate are negligibly changed because the substance containing the silicon atoms or the tin atoms as the n-type impurity atoms is bonded to the surface of the substrate. Therefore, the compound semiconductor substrate of the present invention has target electrical properties of the surface thereof.

A compound semiconductor substrate of the present invention includes a substrate composed of a semi-insulating compound semiconductor; and a substance containing carbon atoms, the substance being bonded to a surface of the substrate. The substance preferably contains hydrocarbon. The hydrocarbon is preferably aromatic hydrocarbon. Furthermore, the substance preferably contains fatty acid or fatty acid derivative.

A compound semiconductor substrate of the present invention includes a substrate composed of a semi-insulating compound semiconductor; and a substance containing iron atoms, the substance being bonded to a surface of the substrate. Furthermore, a compound semiconductor substrate of the present invention includes a substrate composed of a semi-insulating compound semiconductor; and a substance containing chromium atoms, the substance being bonded to a surface of the substrate.

In the compound semiconductor substrate of the present invention, for example, even when p-type or n-type impurities present in an atmosphere adhere to the surface of the substrate, electrical properties of the surface of the substrate are negligibly changed because the substance containing carbon atoms, iron atoms, or chromium atoms is bonded to the surface of the substrate. Thus, the compound semiconductor substrate of the present invention has target electrical properties of the surface. Specifically, the compound semiconductor substrate of the present invention has a high-resistance surface. In particular, the substance containing the iron atoms or the chromium atoms is strongly bonded to the surface of the substrate, thus easily achieving the target electrical properties.

A compound semiconductor substrate of the present invention includes a substrate composed of a compound semiconductor of a first conductive type; and a substance containing impurity atoms of a second conductivity type different from the first conductivity type, the substance being bonded to a surface of the substrate.

In the compound semiconductor substrate of the present invention, the substance containing the impurity atoms of the second conductivity type is bonded to the surface of the substrate. Thus, for example, when an epitaxial layer of the second conductivity type is formed on the surface of the substrate, a pn interface having a thin depletion layer is formed between the substrate and the epitaxial layer. Therefore, the compound semiconductor substrate of the present invention has target electrical properties of the surface.

The concentration of the substance at the surface is preferably in the range of 5 × 10¹¹ to 5 × 10¹⁵ atoms/cm². When the concentration of the substance at the surface is in the above range, target electrical properties of the surface can be easily achieved.

The substrate is preferably composed of GaAs, InP, GaN, or AIN.

An epitaxial substrate of the present invention includes the compound semiconductor substrate of the present invention described above; and a Group III-V compound semiconductor layer disposed on the surface of the compound semiconductor substrate.

In the epitaxial substrate of the present invention, target electrical properties are achieved at the surface of the substrate. Thus, target electrical properties are also achieved at the interface between the substrate and the Group III-V compound semiconductor layer.

An epitaxial substrate of the present invention includes a p-type compound semiconductor layer disposed on a supporting substrate; and a substance containing p-type impurity atoms, the substance being bonded to a surface of the compound semiconductor layer.

In the epitaxial substrate of the present invention, for example, even when n-type impurities present in an atmosphere adhere to the surface of the compound semiconductor layer, electrical properties are negligibly changed because the substance containing the p-type impurity atoms is bonded to the surface of the compound semiconductor layer. Therefore, the epitaxial substrate of the present invention has target electrical properties of the surface.

The substance preferably contains zinc atoms as the impurity atoms. Furthermore, substance preferably contains magnesium atoms as the impurity atoms.

An epitaxial substrate of the present invention includes an n-type compound semiconductor layer disposed on a supporting substrate; and a substance containing silicon atoms as impurity atoms, the substance being bonded to a surface of the compound semiconductor layer. Furthermore, an epitaxial substrate includes an n-type compound semiconductor layer disposed on a supporting substrate; and a substance containing tin atoms as n-type impurity atoms, the substance being bonded to a surface of the compound semiconductor layer.

In the epitaxial substrate of the present invention, for example, even when p-type impurities present in an atmosphere adhere to the surface of the compound semiconductor layer, electrical properties of the surface of the compound semiconductor layer are negligibly changed because the substance containing the silicon atoms or the tin atoms as the n-type impurity atoms is bonded to the surface of the compound semiconductor layer. Therefore, the epitaxial substrate of the present invention has target electrical properties of the surface.

An epitaxial substrate of the present invention includes a compound semiconductor layer of a first conductivity type, the compound semiconductor layer being disposed on a supporting substrate; and a substance containing impurity atoms of a second conductivity type different from the first conductivity type, the substance being bonded to a surface of the compound semiconductor layer.

In the epitaxial substrate of the present invention, the substance containing the impurity atoms of the second conductivity type is bonded to the surface of the compound semiconductor layer. Thus, for example, when an epitaxial layer of the second conductivity type is bonded on the surface of the compound semiconductor layer, a pn interface having a thin depletion layer is formed between the compound semiconductor layer and the epitaxial layer. Therefore, the epitaxial substrate of the present invention has target electrical properties of the surface.

The compound semiconductor layer is preferably composed of a Group III-V compound semiconductor.

The concentration of the substance at the surface is preferably in the range of 5 × 10¹¹ to 5 × 10¹⁵ atoms/cm². When the concentration of the substance at the surface is in the above range, target electrical properties of the surface can be easily achieved.

A process for producing a compound semiconductor substrate includes the steps of polishing a surface of a substrate composed of a compound semiconductor and then cleaning the surface; and treating the cleaned surface of the substrate with a substance containing carbon atoms.

According to the process for producing the compound semiconductor substrate of the present invention, the substance containing the carbon atoms adheres to the surface of the cleaned surface. By virtue of the substance, the resulting compound semiconductor substrate has target electrical properties of the surface. Furthermore, since the surface of the substrate is polished and then cleaned, the target electrical properties are easily achieved.

A process for producing a compound semiconductor substrate includes the step of wet-etching a surface of a substrate composed of a compound semiconductor containing impurity atoms with an etching solution such that the etching rate for the compound semiconductor is higher than that for the impurity atoms.

According to the process for producing the compound semiconductor substrate of the present invention, the substance containing the impurity atoms remains on the surface of the substrate after wet etching. By virtue of the substance, the resulting compound semiconductor substrate has target electrical properties of the surface.

A process for producing an epitaxial substrate, includes the step of wet-etching a surface of a compound semiconductor layer composed of a compound semiconductor containing impurity atoms with an etching solution such that the etching rate for the compound semiconductor is higher than that for the impurity atoms, the compound semiconductor layer being disposed on a supporting substrate.

According to the process for producing the epitaxial substrate of the present invention, the substance containing the impurity atoms remains on the surface of the compound semiconductor layer after wet etching. By virtue of the substance, the resulting epitaxial substrate has target electrical properties of the surface.

### BRIEF DESCRIPTION OF THE DRAWINGS

Figure 1A is a schematic cross-sectional view showing a compound semiconductor substrate in accordance with an embodiment of the present invention;
Figures 1B to 1D are each a schematic cross-sectional view showing a compound semiconductor substrate in accordance with another embodiment of the present invention;
Figure 2A is a schematic cross-sectional view showing an epitaxial substrate in accordance with an embodiment of the present invention;
Figures 2B to 2D are each a schematic cross-sectional view showing an epitaxial substrate in accordance with another embodiment of the present invention;
Figures 3A to 3C are each a schematic cross-sectional view showing an epitaxial substrate in accordance with another embodiment of the present invention;
Figure 4 is a flowchart showing a process for producing a compound semiconductor substrate in accordance with an embodiment of the present invention;
Figure 5 is a flowchart showing a process for producing a compound semiconductor substrate in accordance with another embodiment of the present invention; and
Figure 6 is a graph showing the relationship between the silicon concentration and the photoluminescence (PL) intensity on the surface of a compound semiconductor substrate.

### DETAILED DESCRIPTION OF THE INVENTION

Embodiments of the present invention will be described in detail below referring to the drawings. In the drawings, the same or equivalent elements are designated by the same reference numerals, and redundant description is not repeated.

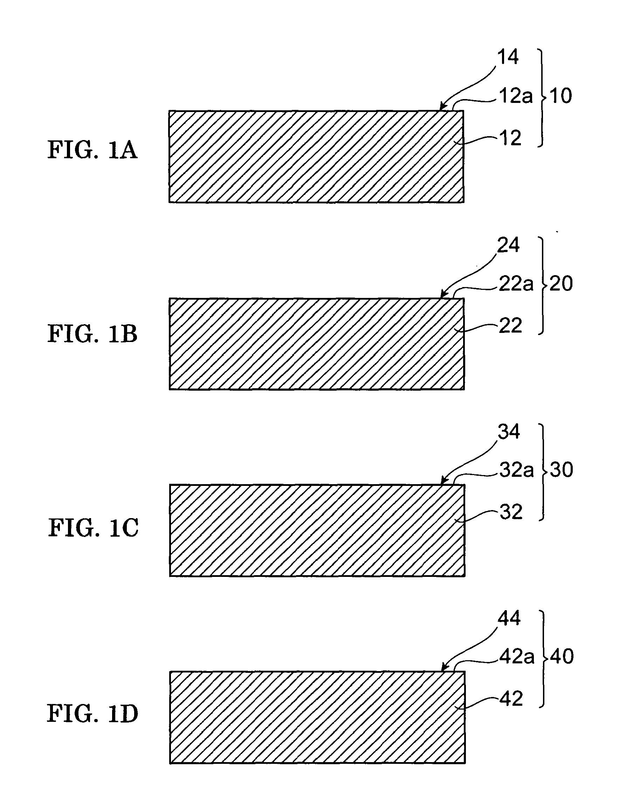

Figure 1A is a schematic cross-sectional view showing a compound semiconductor substrate in accordance with an embodiment of the present invention. A compound semiconductor substrate 10 shown in Fig. 1 includes a substrate 12 composed of a p-type compound semiconductor; and a substance 14 bonded to a surface 12a of the substrate 12 and containing a p-type impurity atoms.

In the compound semiconductor substrate 10, for example, even when n-type impurities present in an atmosphere adhere to the surface 12a of the substrate 12, the electrical properties of the surface 12a of the substrate 12 are negligibly changed. Thus, the compound semiconductor substrate 10 has target electrical properties of the surface 12a.

The substance 14 preferably contains zinc (Zn) atoms or magnesium (Mg) atoms serving as the impurity atoms. Furthermore, the substance 14 may be composed of, for example, a zinc compound or a magnesium compound.

For example, the substance 14 containing zinc is preferably produced by bringing a surface of the substrate 12 doped with zinc into contact with an amine; an aqueous solution of either potassium hydroxide (KOH) or sodium hydroxide (NaOH), the solution optionally containing an aqueous solution of an oxidizer such as hydrogen peroxide; or an aqueous ammonia solution. Alternatively, for example, the substance 14 containing zinc may be produced by bringing a surface of the substrate 12 into contact with an aqueous solution of zinc nitrate; an aqueous solution of zinc chloride; an aqueous solution of zinc ammonium chloride; an aqueous solution of a compound, such as zinc oxalate, prepared from zinc and organic acid; dimethylzinc; or an aqueous solution of a compound, such as zinc laurate, prepared from zinc and fatty acid.

Furthermore, for example, the substance 14 containing magnesium is preferably produced by bringing a surface of the substrate 12 into contact with an aqueous solution of magnesium carbonate hydroxide, magnesium nitrate, or an aqueous solution of a compound, such as magnesium benzoate, prepared from magnesium and organic acid.

Figure 1B is a schematic cross-sectional view showing a compound semiconductor substrate in accordance with another embodiment of the present invention. A compound semiconductor substrate 20 shown in Fig. 1B includes a substrate 22 composed of an n-type compound semiconductor and a substance 24 bonded to a surface 22a of the substrate 22. The substance 24 contains silicon (Si) atoms or tin (Sn) atoms serving as n-type impurity atoms. The substance 24 may contain tellurium (Te) in place of silicon or tin. Furthermore, the substance 24 may be composed of, for example, a silicon compound or a tin compound.

In the compound semiconductor substrate 20, for example, even when p-type impurities present in an atmosphere adhere to the surface 22a of the substrate 22, the electrical properties of the surface 22a of the substrate 22 are negligibly changed. At the same temperature, vapor pressures of silicon and tin are each lower than the vapor pressure of sulfur (S). The substance 24 contains not sulfur but either silicon or tin. Thus, the substance 24 is resistant to vaporization when the compound semiconductor substrate 20 is heated in, for example, epitaxial growth. Therefore, the compound semiconductor substrate 20 has target electrical properties of the surface 22a. Furthermore, the contamination in an epitaxy chamber due to the substance 24 can be prevented.

For example, the substance 24 containing silicon is preferably produced by exposing the surface 22a of the substrate 22 to a silicon compound gas, an aqueous solution of hydrogen hexafluorosilicate, or an aqueous solution of sodium silicate.

For example, the substance 24 containing tin is preferably produced by bringing the surface 22a of the substrate 22 into contact with an aqueous solution of tin chloride, or an aqueous solution of a compound, such as tin oxalate or tin acetate, prepared from tin and organic acid.

Figure 1C is a schematic cross-sectional view showing a compound semiconductor substrate in accordance with another embodiment of the present invention. A compound semiconductor substrate 30 shown in Fig. 1C includes a substrate 32 composed of a semi-insulating compound semiconductor; and a substance 34 bonded to a surface 32a of the substrate 32.

The substance 34 contains carbon (C) atoms, iron (Fe) atoms, or chromium (Cr) atoms. The substance 34 preferably contains hydrocarbon such as aromatic hydrocarbon. Alternatively, the substance 34 may contain fatty acid or fatty acid derivative.

For example, the substance 34 containing carbon is preferably produced by bringing the surface 32a of the substrate 32 into contact with ultrapure water containing aromatic hydrocarbon compound. Alternatively, for example, the surface 32a of the substrate 32 may be brought into contact with fatty acid derivative such as fatty acid ester.

For example, the substance 34 containing iron is preferably produced by bringing the surface 32a of the substrate 32 into contact with aqueous solution of iron(III) phosphate, aqueous solution of iron(III) hydroxide, or aqueous solution of a compound, such as iron oxalate or iron citrate, prepared from iron and organic acid.

For example, the substance 34 containing chromium is preferably produced by bringing the surface 32a of the substrate 32 into contact with aqueous solution of chromium chloride, aqueous solution of chromate such as ammonium chromate, aqueous solution of chromium nitrate, or aqueous solution of a compound, such as chromium acetate, prepared from chromium and organic acid.

In the compound semiconductor substrate 30, for example, even when p-type or n-type impurities present in an atmosphere adhere to the surface 32a of the substrate 32, the electrical properties of the surface 32a of the substrate 32 are negligibly changed. Thus, the compound semiconductor substrate 30 has target electrical properties of the surface 32a. Specifically, the compound semiconductor substrate 30 has the surface 32a with high resistance.

Figure 1D is a schematic cross-sectional view showing compound semiconductor substrate in accordance with another embodiment of the present invention. A compound semiconductor substrate 40 shown in Fig. 1D includes a substrate 42 composed of a compound semiconductor of a first conductivity type; and a substance 44 bonded to a surface 42a of the substrate 42 and containing impurity atoms of a second conductivity type different from the first conductivity type. In an embodiment, the substrate 42 is an n-type GaN substrate, and the substance 44 contains magnesium.

In the compound semiconductor substrate 40, for example, when an epitaxial layer of the second conductivity type is formed on the surface 42a of the substrate 42, a pn interface having a thin depletion layer is formed between the substrate 42 and the epitaxial layer. Thus, the compound semiconductor substrate 40 has target electrical properties of the surface 42a.

In the compound semiconductor substrates 10, 20, 30, and 40, the concentrations of the substances 14, 24, 34, and 44 on the respective surfaces 12a, 22a, 32a, and 42a are each preferably in the range of 5 × 10¹¹ to 5 × 10¹⁵ atoms/cm². When the concentrations of the substances 14, 24, 34, and 44 on the respective surfaces 12a, 22a, 32a, and 42a are each in the above range, it is possible to easily achieve target electrical properties of the surfaces 12a, 22a, 32a, and 42a.

The concentration of the substance 14 is measured by, for example, total reflection X-ray fluorescence spectrometry (TREX or TXRF).

When the concentrations of the substances 14, 24, 34, and 44 are each 5 × 10¹¹ atoms/cm² or more, for example, the compound semiconductor substrates are less subject to the effect of impurities in an atmosphere. When the concentrations of the substances 14, 24, 34, and 44 are each 5 × 10¹⁵ atoms/cm² or less, for example, it is possible to suppress the effect of the substances 14, 24, 34, and 44 on the electrical properties of the respective surfaces 12a, 22a, 32a, and 42a and to reduce the possibility of contaminating an epitaxy chamber.

The substrates 12, 22, 32, and 42 are each preferably composed of GaAs, InP, GaN, or A1N. The substrates 12, 22, 32, and 42 are bulk substrates. Furthermore, preferably, the substrates 12, 22, and 42 each contain a p-type or n-type impurity with a concentration of 5 × 10¹⁴ atoms/cm³ or more.

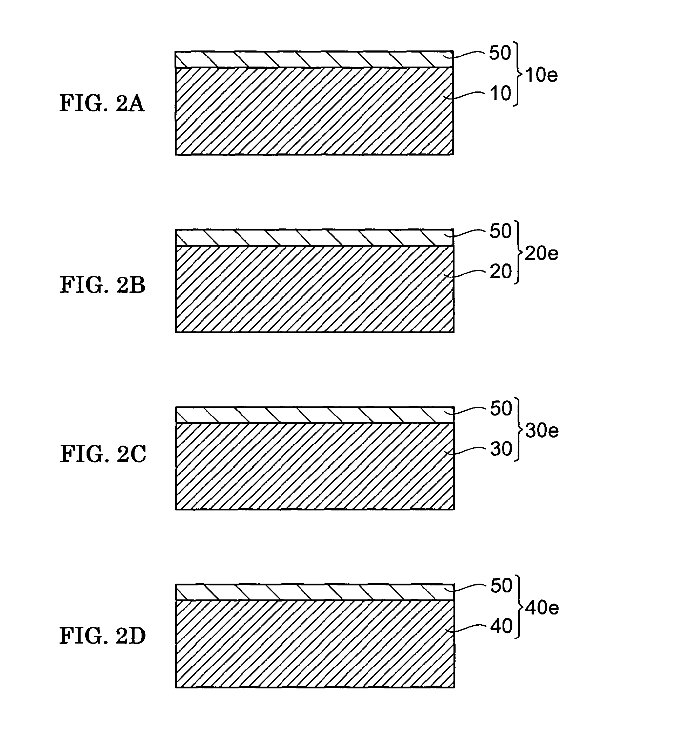

Figure 2A is a schematic cross-sectional view showing an epitaxial substrate in accordance with an embodiment of the present invention. An epitaxial substrate 10e shown in Fig. 2A includes the compound semiconductor substrate 10; and a Group III-V compound semiconductor layer 50 disposed on the surface 12a of the substrate 12 in the compound semiconductor substrate 10.

Figure 2B is a schematic cross-sectional view showing an epitaxial substrate in accordance with another embodiment of the present invention. An epitaxial substrate 20e shown in Fig. 2B includes the compound semiconductor substrate 20; and the Group III-V compound semiconductor layer 50 disposed on the surface 22a of the substrate 22 in the compound semiconductor substrate 20.

Figure 2C is a schematic cross-sectional view showing an epitaxial substrate in accordance with another embodiment of the present invention. An epitaxial substrate 30e shown in Fig. 2C includes the compound semiconductor substrate 30; and the Group III-V compound semiconductor layer 50 disposed on the surface 32a of the substrate 32 in the compound semiconductor substrate 30.

Figure 2D is a schematic cross-sectional view showing an epitaxial substrate in accordance with another embodiment of the present invention. An epitaxial substrate 40e shown in Fig. 2D includes the compound semiconductor substrate 40 and the Group III-V compound semiconductor layer 50 disposed on the surface 42a of the substrate 42 in the compound semiconductor substrate 40.

In the epitaxial substrates 10e, 20e, 30e, and 40e, target electrical properties are achieved at the surfaces 12a, 22a, 32a, and 42a of the respective substrates 12, 22, 32, and 42. Thus, target electrical properties are also achieved at the interface between each of the substrates 12, 22, 32, and 42 and the corresponding Group III-V compound semiconductor layers 50. In particular, the epitaxial substrate 30e has a high-resistance interface between the compound semiconductor substrate 30 and the Group III-V compound semiconductor layer 50. Accordingly, a compound semiconductor device, such as a high electron mobility transistor (HEMT), including the epitaxial substrate 30e has a very low leakage current.

Preferably, the Group III-V compound semiconductor layer 50 contains at least one element selected from gallium (Ga), indium (In), and aluminum (Al), which are Group III elements; and at least one element selected from arsenic (As), phosphorus (P), and nitrogen (N), which are Group V elements.

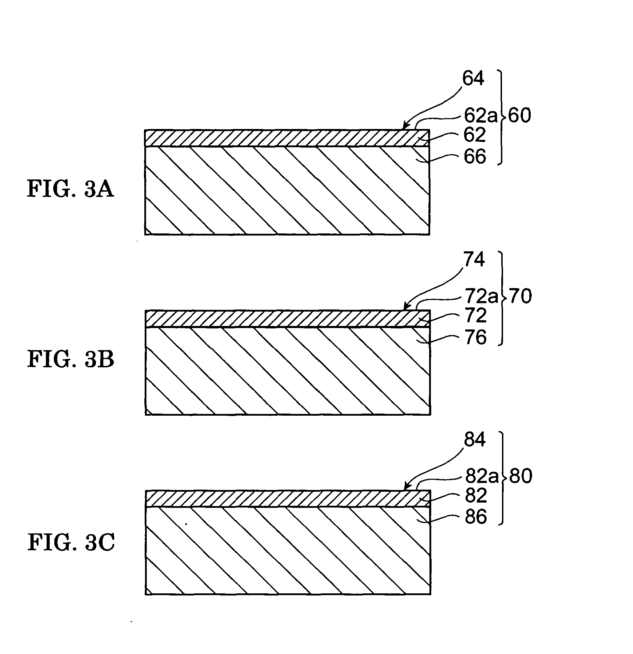

Figure 3A is a schematic cross-sectional view showing an epitaxial substrate in accordance with another embodiment of the present invention. An epitaxial substrate 60 shown in Fig. 3A includes a p-type compound semiconductor layer 62 on a supporting substrate 66; and a substance 64 bonded to a surface 62a of the compound semiconductor layer 62 and containing p-type impurity atoms. Examples of the substance 64 are the same as those of the substance 14.

In the epitaxial substrate 60, for example, even when n-type impurities present in an atmosphere adhere to the surface 62a of the compound semiconductor layer 62, the electrical properties of the surface 62a of the compound semiconductor layer 62 are negligibly changed. Thus, the epitaxial substrate 60 has target electrical properties of the surface 62a.

Figure 3B is a schematic cross-sectional view showing an epitaxial substrate in accordance with another embodiment of the present invention. An epitaxial substrate 70 shown in Fig. 3B includes an n-type compound semiconductor layer 72 disposed on a supporting substrate 76; and a substance 74 bonded to a surface 72a of the compound semiconductor layer 72. Examples of the substance 74 are the same as those of the substance 24.

In the epitaxial substrate 70, for example, even when p-type impurities present in an atmosphere adhere to the surface 72a of the compound semiconductor layer 72, electrical properties of the surface 72a of the compound semiconductor layer 72 are negligibly changed. Furthermore, the substance 74 contains not sulfur but either silicon or tin. Thus, the substance 74 is resistant to vaporization when the epitaxial substrate 70 is heated in, for example, epitaxial growth. Therefore, the epitaxial substrate 70 has target electrical properties of the surface 72a.

Figure 3C is a schematic cross-sectional view showing an epitaxial substrate in accordance with another embodiment of the present invention. An epitaxial substrate 80 shown in Fig. 3C includes a compound semiconductor layer 82 of a first conductivity type, the compound semiconductor layer 82 being disposed on a supporting substrate 86; and a substance 84 bonded to a surface 82a of the compound semiconductor layer 82 and containing impurity atoms of a second conductivity type different from the first conductivity type. Examples of the substance 84 are the same as those of the substance 44.

In the epitaxial substrate 80, for example, when an epitaxial layer of the second conductivity type is formed on the surface 82a of the compound semiconductor layer 82, a pn interface having a thin depletion layer is formed between the compound semiconductor layer 82 and the epitaxial layer. Thus, the epitaxial substrate 80 has target electrical properties of the surface 82a.

Preferably, the compound semiconductor layers 62, 72, and 82 are each composed of a Group III-V compound semiconductor.

Furthermore, in the epitaxial substrates 60, 70, and 80, preferably, the concentrations of the substances 64, 74, and 84 on the respective surfaces 62a, 72a, and 82a are each in the range of 5 × 10¹¹ to 5 × 10¹⁵ atoms/cm². When the concentrations of the substances 64, 74, and 84 on the respective surfaces 62a, 72a, and 82a are each in the above range, it is possible to easily achieve target electrical properties of the surfaces 62a, 72a, and 82a.

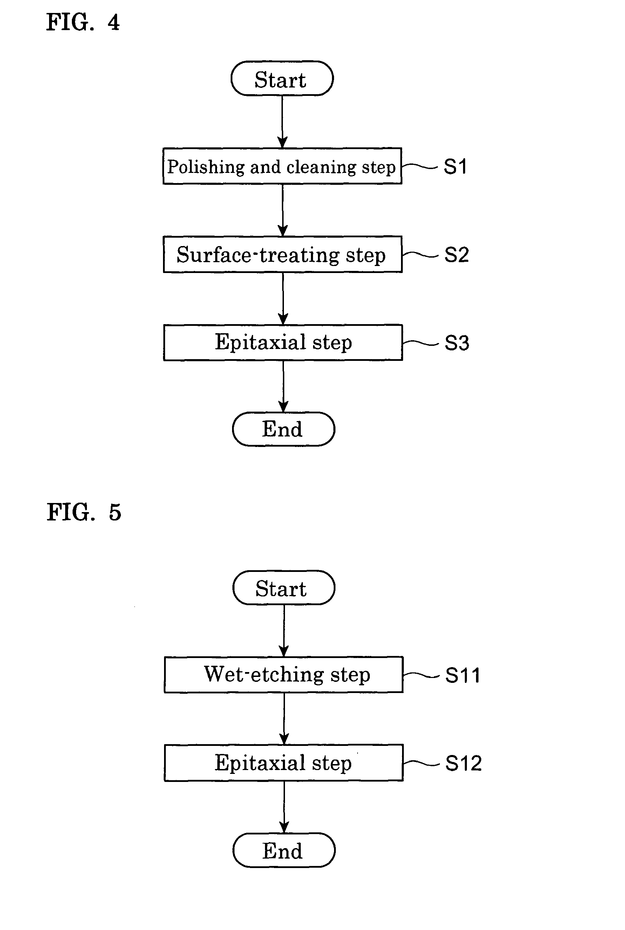

Figure 4 is a flowchart of a process for producing a compound semiconductor substrate in accordance with an embodiment of the present invention. The process for producing the compound semiconductor substrate in accordance with the embodiment includes a polishing and cleaning step S1; and a surface-treating step S2 subsequent to the polishing and cleaning step S1. The process may further include an epitaxial step S3 subsequent to the surface-treating step S2.

The process for producing the compound semiconductor substrate in accordance with the embodiment of the present invention can suitably provides the compound semiconductor substrate 30 shown in Fig. 1C and the epitaxial substrate 30e shown in Fig. 2C. The process for producing the compound semiconductor substrate 30 and the epitaxial substrate 30e will be described below.

In the polishing and cleaning step S1, a surface of a substrate composed of a compound semiconductor is polished and then cleaned. Cleaning is preferably performed with acid or alkali.

In the surface-treating step S2, the resulting cleaned surface of the substrate is treated with a substance containing carbon atoms. As a result, the substance 34 containing the carbon atoms adheres to the surface 32a of the substrate 32, thereby producing the compound semiconductor substrate 30.

Examples of the substance containing the carbon atoms include hydrocarbon compounds such as aromatic hydrocarbons; fatty acids; and fatty acid derivatives such as fatty acid esters.

In the epitaxial step S3, as shown in Fig. 2C, the Group III-V compound semiconductor layer 50 is formed on the surface 32a of the substrate 32 in the compound semiconductor substrate 30.

Figure 5 is a flowchart of a process for producing a compound semiconductor substrate in accordance with another embodiment of the present invention. The process for producing the compound semiconductor substrate in accordance with the embodiment includes a wet-etching step S11. An epitaxial step S12 may be performed subsequent to the wet-etching step S11.

The process for producing the compound semiconductor substrate in accordance with the embodiment suitably provides the compound semiconductor substrates 10 and 20 shown in Figures 1A and 1B. An exemplary process for producing the compound semiconductor substrate 10 will be described below. The compound semiconductor substrate 20 can be produced in the same way as for the compound semiconductor substrate 10.

In the wet-etching step S11, a surface of a substrate composed of a compound semiconductor containing impurity atoms is wet-etched with an etching solution. With respect to the etching solution, an etching solution such that the etching rate for the compound semiconductor is higher than that for the impurity atoms is used. Thus, the substance 14 containing the impurity atoms remains on the surface of the substrate. The compound semiconductor substrate 10 is thereby produced.

For example, the substance 14 containing zinc is preferably produced by wet-etching the surface of the substrate with an aqueous ammonia solution.

In the epitaxial step S12, the Group III-V compound semiconductor layer 50 is formed on the surface 12a of the substrate 12 in the compound semiconductor substrate 10.

A process for producing an epitaxial substrate in accordance with an embodiment of the present invention includes the wet-etching step S11. The epitaxial step S12 may be performed subsequent to the wet-etching step S11.

The process for producing the epitaxial substrate in accordance with the embodiment suitably provides the epitaxial substrates 60 and 70 shown in the Figures 3A and 3B. An exemplary process for producing the epitaxial substrate 60 will be described below. The epitaxial substrate 70 can be produced in the same way as for the epitaxial substrate 60.

In the wet-etching step S11, a surface of a compound semiconductor layer composed of a compound semiconductor containing impurity atoms is wet-etched with an etching solution. With respect to the etching solution, an etching solution such that the etching rate for the compound semiconductor is higher than that for the impurity atoms is used. Thus, the substance 64 containing the impurity atoms remains on the surface 62a of the compound semiconductor layer 62. The epitaxial substrate 60 is thereby produced.

For example, the substance 64 containing zinc is preferably produced by wet-etching a surface of a compound semiconductor layer with an aqueous ammonia solution.

In the epitaxial step S12, a Group III-V compound semiconductor layer is formed on the surface 62a of the compound semiconductor layer 62 in the epitaxial substrate 60, thereby forming a high-resistance interface between the compound semiconductor layer 62 and the Group III-V compound semiconductor layer.

Hereinbefore, the preferred embodiments of the present invention have been described in detail. However, the present invention is not limited to the embodiments.

### EXAMPLES

The present invention will now be described in detail on the basis of examples. However, the present invention is not limited to the examples described below.

### EXAMPLE 1

One surface of a p-type wafer composed of gallium arsenide (GaAs) doped with zinc was polished with an abrasive to form a mirror-finished surface. The resulting surface of the wafer was wet-etched with an etching solution containing an aqueous ammonia solution and hydrogen peroxide. Zinc easily remains on the surface of the wafer due to low solubility of zinc in the aqueous ammonia solution. Thereby, a compound semiconductor substrate including a substance containing zinc bonded to the surface thereof was produced in Example 1. The zinc concentration at the surface of the compound semiconductor substrate produced in Example 1 was an order of magnitude higher than that at the surface of a typical compound semiconductor substrate and was determined to be 5 × 10¹¹ atoms/cm². The zinc concentration was measured with a total reflection X-ray fluorescence spectrometer (Model: TREX 610, manufactured by Technos Co., Ltd).

Subsequently, an n-type epitaxial layer was formed on the surface of the resulting compound semiconductor substrate produced in Example 1. As a result, a pn interface having a thin depletion layer can be easily formed between the compound semiconductor substrate and the epitaxial layer.

### EXAMPLE 2

One surface of a wafer composed of n-type gallium arsenide (GaAs) doped with silicon at a concentration of 5 × 10¹⁸ atoms/cm³ was polished and then cleaned. The resulting wafer was left standing in a silicon compound gas. Thereby, a compound semiconductor substrate including the silicon compound adhering to the surface thereof was produced in Example 2.

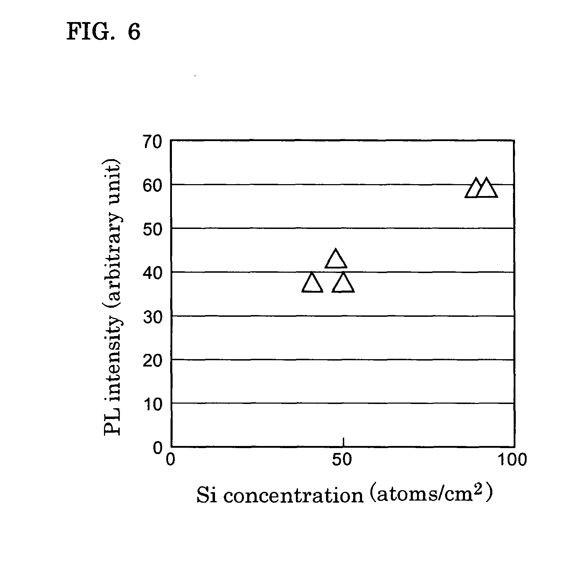

Subsequently, an AlGaInP layer was formed by epitaxial growth on the surface of the compound semiconductor substrate produced in Example 2 to produce an epitaxial substrate. The photoluminescence (PL) of the resulting epitaxial substrate was measured. Figure 6 shows the results. Figure 6 is a graph showing the relationship between the silicon concentration at the surface of the compound semiconductor substrate and the PL intensity. The graph shows the tendency of the PL intensity to increase with increasing silicon concentration at the surface. The silicon concentration was measured in the same way as for the zinc concentration.

### EXAMPLE 3

A carbon-doped GaAs ingot having a resistivity of 1 × 10⁷ to 1 × 10⁹ Ωcm was prepared. A semi-insulating GaAs wafer was cut from the ingot with a wire saw. One surface of the resulting wafer was polished so that irregularities of the surface were substantially removed. Specifically, polishing was performed so that the surface roughness Rq (also referred to as "Rms") was less than 0.3 µm in a 10 µm × 10 µm square. The surface of the wafer was treated with acid or alkali to remove abrasives or particles remaining on the surface of the wafer. Subsequently, the surface of the wafer was treated with ultrapure water containing 30 ppb of an aromatic hydrocarbon compound. Thereby, a compound semiconductor substrate including the aromatic hydrocarbon compound adhering to the surface thereof was produced in Example 3. The carbon concentration at the surface of the resulting compound semiconductor substrate was determined to be 1 × 10¹⁶ atoms/cm². The carbon concentration was measured with a Marcus-type radio frequency glow discharge optical emission spectrometer (GD-OES) (Model: JY-5000RF, manufactured by Horiba Jobin Yvon Inc). Furthermore, the carbon concentration was measured by X-ray photoelectron spectroscopy (XPS) and determined to be about 10%. In XPS, the take-off angle for the photoelectrons was set to 90°, and the percentage of the number of carbon atoms was calculated on the basis of the intensity ratio of the total elements detected.

Subsequently, a GaAs layer was formed by molecular beam epitaxy (MBE) on the surface of the compound semiconductor substrate produced in Example 3 to form an epitaxial substrate. The carbon concentration in the interface between the compound semiconductor substrate and the GaAs layer was measured by secondary ion mass spectrometry (SIMS). As a result, the carbon concentration was an order of magnitude higher than that in the interface between a typical compound semiconductor substrate and a GaAs layer and was determined to be 1 × 10¹⁹ atoms/cm³. Consequently, it was possible to form a high-resistance interface between the compound semiconductor substrate and the GaAs layer.

An enhancement-mode high-electron-mobility transistor (HEMT) was produced with the resulting epitaxial substrate. The resulting HEMT had a very low leakage current.

### EXAMPLE 4

A carbon-doped semi-insulating GaAs wafer was prepared. The carbon concentration in the wafer was determined to be 1 × 10¹⁵ atoms/cm³. One surface of the wafer was polished and then cleaned with organic agent, alkali agent, and acid agent. After cleaning, the surface of the wafer was rinsed with water and then dried. The wafer was left standing in vapor of higher fatty acid. Thereby, a compound semiconductor substrate including the higher fatty acid adhering to the surface thereof was produced in Example 4. The carbon concentration at the surface of the resulting compound semiconductor substrate was determined to be 5 × 10¹⁵ atoms/cm². The carbon concentration was measured with a Marcus-type radio frequency glow discharge optical emission spectrometer (GD-OES) (Model: JY-5000RF, manufactured by Horiba Jobin Yvon Inc).

Subsequently, an epitaxial layer was formed by MBE on the surface of the compound semiconductor substrate produced in Example 4 to produce an epitaxial substrate. The carbon concentration the interface between the compound semiconductor substrate and the epitaxial layer was measured by SIMS and was determined to be 1 × 10¹⁹ atoms/cm³. Consequently, it was possible to form a high-resistance interface between the compound semiconductor substrate and the epitaxial layer.

### EXAMPLE 5

A semi-insulating wafer was cut from an iron-doped high-resistance indium phosphide (InP) ingot, and both surfaces of the wafer were lapped. Then, one surface of the wafer was polished so that the surface roughness Rq was less than 0.2 µm in a 2 µm × 2 µm square. The surface of the wafer was cleaned with organic agent, acid agent, and alkali agent. Subsequently, the surface of the wafer was rinsed with water and then spin-dried. Then, the wafer was left standing in vapor of fatty acid ester for a predetermined time. Thereby, a compound semiconductor substrate including the fatty acid ester adhering to the surface thereof was produced in Example 5. The carbon concentration of the surface of the resulting compound semiconductor substrate was determined to be 5 × 10¹⁵ atoms/cm². The carbon concentration was measured with a Marcus-type radio frequency glow discharge optical emission spectrometer (GD-OES) (Model: JY-5000RF, manufactured by Horiba Jobin Yvon Inc).

Subsequently, an epitaxial layer was formed by metallorganic chemical vapor deposition on the surface of the compound semiconductor substrate produced in Example 5 to produce an epitaxial substrate. As a result, it was possible to reduce the leakage current at the interface between the compound semiconductor substrate and the epitaxial layer.

### EXAMPLE 6

An oxygen-doped n-type gallium nitride (GaN) substrate was prepared. The GaN substrate was subjected to mirror polishing and then was cleaned with acid or alkali. After cleaning, the GaN substrate was rinsed with deionized water. Next, the surface of the GaN substrate was treated with an aqueous solution of magnesium carbonate hydroxide, rinsed with ultrapure water, and dried. Thereby, a compound semiconductor substrate including magnesium carbonate hydroxide adhering to the surface thereof was produced in Example 6. The magnesium concentration at the surface of the resulting compound semiconductor substrate was determined to be 1 × 10¹³ atoms/cm². The magnesium concentration was measured in the same way as for the zinc concentration.

Subsequently, a magnesium-doped GaN layer was epitaxially grown on the surface of the compound semiconductor substrate produced in the Example 6 to produce an epitaxial substrate. The magnesium concentration in the GaN layer was determined to be 5 × 10¹⁹ atoms/cm³. Thus, a pn interface having a thin depletion layer was formed between the compound semiconductor substrate and the GaN layer.

## Claims

1. A compound semiconductor substrate comprising:
a substrate composed of a p-type compound semiconductor; and
a substance containing p-type impurity atoms, the substance being bonded to a surface of the substrate.

2. The compound semiconductor substrate according to claim 1, wherein the substance contains zinc atoms as the impurity atoms.

3. The compound semiconductor substrate according to claim 1 or 2, wherein the substance contains magnesium atoms as the impurity atoms.

4. A compound semiconductor substrate comprising:
a substrate composed of an n-type compound semiconductor; and
a substance containing silicon atoms as n-type impurity atoms, the substance being bonded to a surface of the substrate.

5. A compound semiconductor substrate comprising:
a substrate composed of an n-type compound semiconductor; and
a substance containing tin atoms as n-type impurity atoms, the substance being bonded to a surface of the substrate.

6. A compound semiconductor substrate comprising:
a substrate composed of a semi-insulating compound semiconductor; and
a substance containing carbon atoms, the substance being bonded to a surface of the substrate.

7. The compound semiconductor substrate according to claim 6, wherein the substance contains a hydrocarbon.

8. The compound semiconductor substrate according to claim 7, wherein the hydrocarbon is an aromatic hydrocarbon.

9. The compound semiconductor substrate according to any one of claims 6 to 8, wherein the substance contains fatty acid or fatty acid derivative.

10. A compound semiconductor substrate comprising:
a substrate composed of a semi-insulating compound semiconductor; and
a substance containing iron atoms, the substance being bonded to a surface of the substrate.

11. A compound semiconductor substrate comprising:
a substrate composed of a semi-insulating compound semiconductor; and
a substance containing chromium atoms, the substance being bonded to a surface of the substrate.

12. A compound semiconductor substrate comprising:
a substrate composed of a compound semiconductor of a first conductive type; and
a substance containing impurity atoms of a second conductivity type different from the first conductivity type, the substance being bonded to a surface of the substrate.

13. The compound semiconductor substrate according to any one of claims 1 to 12, wherein the concentration of the substance at the surface is in the range of 5 × 10¹¹ to 5 × 10¹⁵ atoms/cm².

14. The compound semiconductor substrate according to any one of claims 1 to 13, wherein the substrate comprises GaAs, InP, GaN, or AlN.

15. An epitaxial substrate comprising:
the compound semiconductor substrate according to any one of claims 1 to 14; and
a Group III-V compound semiconductor layer disposed on the surface of the compound semiconductor substrate.

16. An epitaxial substrate comprising:
a p-type compound semiconductor layer disposed on a supporting substrate; and
a substance containing p-type impurity atoms, the substance being bonded to a surface of the compound semiconductor layer.

17. The epitaxial substrate according to claim 16, wherein the substance contains zinc atoms as the impurity atoms.

18. The epitaxial substrate according to claim 16 or 17, wherein the substance contains magnesium atoms as the impurity atoms.

19. An epitaxial substrate comprising:
an n-type compound semiconductor layer disposed on a supporting substrate; and
a substance containing silicon atoms as impurity atoms, the substance being bonded to a surface of the compound semiconductor layer.

20. An epitaxial substrate comprising:
an n-type compound semiconductor layer disposed on a supporting substrate; and
a substance containing tin atoms as n-type impurity atoms, the substance being bonded to a surface of the compound semiconductor layer.

21. An epitaxial substrate comprising:
a compound semiconductor layer of a first conductivity type, the compound semiconductor layer being disposed on a supporting substrate; and
a substance containing impurity atoms of a second conductivity type different from the first conductivity type, the substance being bonded to a surface of the compound semiconductor layer.

22. The epitaxial substrate according to any one of claims 16 to 21, wherein the compound semiconductor layer comprises a Group III-V compound semiconductor.

23. The epitaxial substrate according to any one of claims 16 to 22, wherein the concentration of the substance at the surface is in the range of 5 × 10¹¹ to 5 × 10¹⁵ atoms/cm².

24. A process for producing a compound semiconductor substrate, comprising the steps of:
polishing a surface of a substrate composed of a compound semiconductor and then cleaning the surface; and
treating the cleaned surface of the substrate with a substance containing carbon atoms.

25. A process for producing a compound semiconductor substrate, comprising the step of:
wet-etching a surface of a substrate composed of a compound semiconductor containing impurity atoms with an etching solution such that the etching rate for the compound semiconductor is higher than that for the impurity atoms.

26. A process for producing an epitaxial substrate, comprising the step of:
wet-etching a surface of a compound semiconductor layer composed of a compound semiconductor containing impurity atoms with an etching solution such that the etching rate for the compound semiconductor is higher than that for the impurity atoms, the compound semiconductor layer being disposed on a supporting substrate.
